# EUROPÄISCHE PATENTSCHRIFT

(11) **EP 3 270 667 B1**
(45) Veröffentlichungstag und Bekanntmachung des Hinweises auf die Patenterteilung: **07.11.2018**
(21) Anmeldenummer: 17181395.9
(22) Anmeldetag: 14.07.2017
(51) Int. Cl.: H05K 5/06, F21V 31/00

(54) **ANORDNUNG ZUR BILDUNG EINES ABGEDICHTETEN INNENRAUMBEREICHS**
ASSEMBLY FOR FORMING A SEALED INTERIOR AREA
SYSTÈME DE FORMATION D'UNE ZONE D'ESPACE INTÉRIEUR ÉTANCHE

(30) Priorität: 14.07.2016 DE 202016103789 U
(43) Veröffentlichungstag der Anmeldung: 17.01.2018
(73) Patentinhaber: Zumtobel Lighting GmbH, 6850 Dornbirn (AT)
(72) Erfinder: Feurle, Helmut, 6934 Sulzberg (AT); Fussenegger, Tanja, 6850 Dornbirn (AT); Spiegel, Michael, 6850 Dornbirn (AT)
(74) Vertreter: Thun, Clemens

(56) Entgegenhaltungen:
- JP-A- 2010 153 784
- US-A1- 2010 246 146

## Beschreibung

Die Erfindung betrifft eine Anordnung zur Bildung eines abgedichteten, insbesondere feuchtigkeitsdicht abgedichteten Innenraumbereichs.

Aus dem Stand der Technik ist eine derartige Anordnung in Form einer - noch nicht zusammengebauten - Feuchtraumleuchte bekannt. Die Feuchtraumleuchte weist ein erstes Begrenzungselement in Form eines Gehäuses auf und ein zweites Begrenzungselement in Form einer Abdeckung für das Gehäuse, wobei die Abdeckung mit dem Gehäuse über einen ringartig geformten Verbindungsbereich derart verbunden werden kann, dass ein Innenraumbereich gebildet ist. In dem Innenraum befindet sich unter anderem eine Lichtquelle der Feuchtraumleuchte, die vor einem Eindringen von Staub und Feuchtigkeit geschützt werden soll. Zur Erzeugung einer geeigneten Abdichtung des Verbindungsbereichs ist ein Dichtstoff in Form eines elastischen Dichtelements vorgesehen. Zur Festlegung eines Grades der Dichtheit kann bekanntlich die Angabe der so genannten Schutzart dienen.

Zur Herstellung der Verbindung von Gehäuse und Abdeckung wird das Dichtelement wie vorgesehen in dem Verbindungsbereich positioniert, beispielsweise in einem umlaufenden U-förmigen Kanal, der am Rand der Abdeckung gebildet ist; anschließend werden das Gehäuse und die Abdeckung zusammengepresst. Um den Druck auf das Dichtelement dauerhaft aufrechtzuerhalten, sind Rastverschlüsse vorgesehen, die zwischen dem Gehäuse und der Abdeckung wirken.

Problematisch bei dieser Anordnung ist es, eine ausreichende Dichtigkeit für einen längeren Zeitraum, beispielsweise über Jahre hinweg sicherzustellen. Dies hängt mit dem zwischen dem Gehäuse und der Abdeckung wirkenden Anpressdruck und auch mit dem Material des Dichtelements zusammen. In der Praxis wirkt dies beispielsweise limitierend auf die die Höhe der Schutzart der Feuchtraumleuchte, die gewährleistet werden kann.

Um eine besonders gute Dichtigkeit zu erzielen, ist es grundsätzlich möglich, das Gehäuse und die Abdeckung am Verbindungsbereich zusammenzukleben. Dies führt allerdings - beispielsweise im Fall einer Leuchte - im Allgemeinen zu praktischen Problemen, denn im Rahmen einer Montage der Leuchte am vorgesehenen Betriebsort muss der Monteur, bei dem es sich in der Regel um einen Elektriker handelt, im Allgemeinen innerhalb des Innenraums der Leuchte hantieren, beispielsweise zur Kontrolle der Funktionsfähigkeit der Leuchte. Daher muss die Leuchte in einem noch nicht verklebten Zustand an den Betriebsort geliefert werden. Somit ist es erforderlich, dass die Verklebung dementsprechend von dem Monteur oder gegebenenfalls einer anderen Person vor Ort hergestellt wird. Daher ist es wünschenswert, ein entsprechendes Verkleben zu ermöglichen, das möglichst einfach durchgeführt werden kann.

Aus der US 2010/0246146 A1 ist eine Anordnung zur Herstellung eines elektronischen Schlüssels bekannt, der eine Leiterplatte und eine Dekor-Platte aufweist. Die Anordnung umfasst zwei Formteile zur Herstellung eines Harz-Elements, das zur Verbindung der Leiterplatte mit der Dekor-Platte dient.

Aus der JP 2010-153784 A ist eine Anschlussbox eines Solarmoduls mit einem Gehäuse und einer Abdeckung bekannt. Zur Herstellung eines abgedichteten Innenraumbereichs wird zunächst Kunststoff in das Gehäuse eingefüllt und anschließend die Abdeckung auf das Gehäuse aufgesetzt.

Der Erfindung liegt die Aufgabe zugrunde, eine Anordnung zur Bildung eines abgedichteten, insbesondere feuchtigkeitsdicht abgedichteten Innenraumbereichs bereitzustellen; insbesondere soll es mit der Anordnung ermöglicht sein, die dichte Verbindung möglichst einfach herzustellen.

Diese Aufgabe wird gemäß der Erfindung mit dem in dem unabhängigen Anspruch genannten Gegenstand gelöst. Besondere Ausführungsarten der Erfindung sind in den abhängigen Ansprüchen angegeben.

Gemäß der Erfindung ist eine Anordnung zur Bildung eines abgedichteten, insbesondere feuchtigkeitsdicht abgedichteten Innenraumbereichs vorgesehen, die ein erstes Begrenzungselement zur Bildung des Innenraumbereichs aufweist, sowie ein zweites Begrenzungselement zur Bildung des Innenraumbereichs. Bei dem ersten Begrenzungselement handelt es sich um ein Gehäuse einer Leuchte und bei dem zweiten Begrenzungselement um eine Abdeckung der Leuchte.

Dabei kann das erste Begrenzungselement mit dem zweiten Begrenzungselement über einen, insbesondere ringartig geformten Verbindungsbereich derart verbunden werden, dass hierdurch der Innenraumbereich gebildet ist. Weiterhin umfasst die Anordnung einen Dichtstoff zur Erzeugung einer Abdichtung des Verbindungsbereichs. Außerdem weist die Anordnung weiterhin eine Aufnahmekammer für einen geschlossenen Behälter auf, in dem sich der Dichtstoff befindet, ein Öffnungselement für ein Öffnen des Behälters, sowie einen, von der Aufnahmekammer zu dem abzudichtenden Verbindungsbereich führenden Kanal für den Dichtstoff.

Durch die Aufnahmekammer und den Behälter mit dem Dichtstoff ist eine besonders einfache Handhabung zur Herstellung der Abdichtung des Verbindungsbereichs ermöglicht. Insbesondere lässt sich so erzielen, dass sich der Dichtstoff zu Beginn der Herstellung bereits besonders nahe an dem Verbindungsbereich befindet. Durch den Kanal ist dabei eine besonders vorteilhafte Führung des Dichtstoffs von dem Behälter zu dem Verbindungsbereich ermöglicht.

Vorzugsweise ist das Öffnungselement dazu ausgestaltet, das Öffnen des Behälters durch ein Aufstechen des Behälters zu erzielen. Hierdurch ist bei einfacher Handhabung ein sicheres und schnelles Öffnen des Behälters ermöglicht.

Vorzugsweise ist der Kanal sich durch das Öffnungselement hindurch erstreckend gestaltet. So lässt sich erzielen, dass der Weg des Dichtstoffs von dem Behälter zu dem Kanal besonders kurz ist. Außerdem ist hierdurch die Gefahr eines unerwünschten Blockierens desjenigen Endbereichs des Kanals, der sich in der Aufnahmekammer befindet, besonders gering.

Vorzugsweise umfasst die Anordnung weiterhin ein Betätigungselement, wobei die Gestaltung derart ist, dass das Betätigungselement durch eine Manipulation von außerhalb des Innenraumbereichs derart betätigt werden kann, dass hierdurch das Öffnen des Behälters bewirkt wird sowie ein anschließendes Strömen des Dichtstoffs durch den Kanal zu dem Verbindungsbereich. Durch diese Gestaltung ist die Handhabung weiterhin vereinfacht.

Vorzugsweise kann dabei durch die Manipulation des Betätigungselements eine zum Öffnen des Behälters führende Relativbewegung zwischen dem Behälter und dem Öffnungselement bewirkt werden. Auf diese Weise ist bei einfacher Gestaltungsmöglichkeit und Handhabung des Betätigungselements ein zuverlässiges Öffnen des Behälters ermöglicht. Dabei wird besonders bevorzugt durch die Relativbewegung das Aufstechen des Behälters erzielt.

Vorzugsweise ist das Betätigungselement für die Manipulation beweglich an dem ersten Begrenzungselement gelagert. Auf diese Weise ist insbesondere eine besonders kurze Wirkstrecke zwischen dem Betätigungselement und dem Behälter ermöglicht. Auch lässt sich so praktisch verhindern, dass das Betätigungselement verlorengeht.

Vorzugsweise ist die Gestaltung derart, dass die Manipulation des Betätigungselements eine Translationsbewegung des Betätigungselements oder eine Drehbewegung des Betätigungselements umfasst, vorzugsweise aus einer Translationsbewegung des Betätigungselements und/oder aus einer Drehbewegung des Betätigungselements besteht. So ist eine besonders einfach durchzuführende Manipulation ermöglicht.

Vorzugsweise umfasst die Anordnung weiterhin eine Sicherungseinrichtung zur Verhinderung einer ungewollten Durchführung der Manipulation des Betätigungselements.

Vorzugsweise ist die Aufnahmekammer als ein Bestandteil des ersten Begrenzungselements ausgestaltet, wobei das erste Begrenzungselement vorzugsweise als aus einem Stück bestehend gestaltet ist. Dies ist insbesondere vorteilhaft mit Bezug auf eine raumsparende Ausgestaltung der Anordnung.

Vorzugsweise ist der Kanal als ein weiterer Bestandteil des ersten Begrenzungselements ausgestaltet. Dies ist insbesondere vorteilhaft mit Bezug auf eine raumsparende Ausgestaltung der Anordnung.

Vorzugsweise weist die Anordnung außerdem wenigstens einen weiteren Kanal für den Dichtstoff auf, der von der Aufnahmekammer zu dem abzudichtenden Verbindungsbereich führend gestaltet ist. So lässt sich der Dichtstoff vorteilhaft zu unterschiedlichen Stellen des Verbindungsbereichs leiten.

Besonders eignet sich die Anordnung, wenn das erste Begrenzungselement und/oder das zweite Begrenzungselement Bestandteile einer Leuchte sind oder einer elektrischen Anschluss- oder Verteilerbox.

Die Erfindung wird im Folgenden anhand eines Ausführungsbeispiels und mit Bezug auf die Zeichnungen näher erläutert. Es zeigen:
- Fig. 1: eine Querschnitt-Skizze zu einem ersten Ausführungsbeispiel einer anmeldungsgemäßen Anordnung und
- Fig. 2: eine Querschnitt-Skizze zu einem zweiten Ausführungsbeispiel einer anmeldungsgemäßen Anordnung.

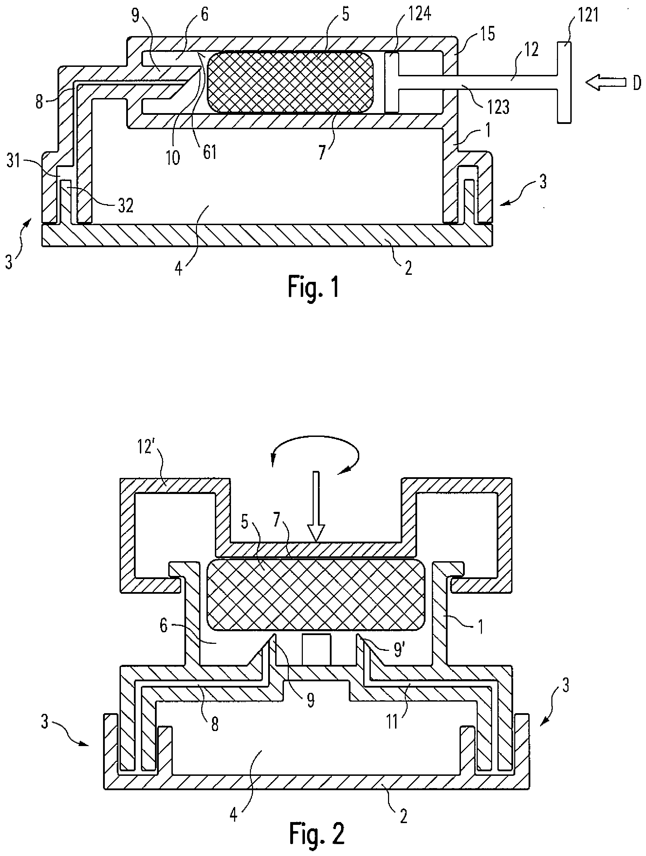

Fig. 1 zeigt eine schematische Querschnitt-Skizze zu einem ersten Ausführungsbeispiel einer anmeldungsgemäßen Anordnung zur Bildung eines abgedichteten, insbesondere feuchtigkeitsdicht abgedichteten Innenraumbereichs 4.

Die Anordnung weist ein erstes Begrenzungselement 1 zur Bildung des Innenraumbereichs 4 auf, sowie ein zweites Begrenzungselement 2 zur Bildung des Innenraumbereichs 4. Bei dem ersten Begrenzungselement 1 kann es sich insbesondere um ein Gehäuse einer Leuchte, bei dem zweiten Begrenzungselement 2 um eine Abdeckung der Leuchte oder auch andersherum. Bei der Leuchte kann es sich insbesondere um eine Feuchtraumleuchte handeln.

Das erste Begrenzungselement 1 kann dabei mit dem zweiten Begrenzungselement 2 über einen Verbindungsbereich 3 derart verbunden werden, dass hierdurch der Innenraumbereich 4 gebildet ist. Der Verbindungsbereich 3 ist dabei vorzugsweise geschlossen umlaufend bzw. ringartig geformt gestaltet. Im skizzierten Beispiel verläuft der Verbindungsbereich 3 in einer Ebene normal zu der Zeichenebene, so dass im skizzierten Querschnitt der Verbindungsbereich 3 an zwei Stellen zu erkennen ist.

Der Verbindungsbereich 3 kann beispielsweise einen umlaufenden, im Querschnitt U-förmigen Kanal 31 aufweisen, der beispielsweise wie skizziert an einem Randbereich des ersten Begrenzungselements 1 bzw. des Gehäuses der Leuchte ausgebildet ist. Außerdem kann der Verbindungsbereich 3 einen umlaufenden Steg 32 aufweisen, der in den U-förmigen Kanal 31 eingreift, wenn die beiden Begrenzungselemente 1, 2 wie vorgesehen miteinander verbunden sind. Der Steg 32 kann beispielsweise wie skizziert an einem Randbereich des zweiten Begrenzungselements 2 bzw. der Abdeckung der Leuchte ausgebildet sein.

Weiterhin weist die Anordnung einen Dichtstoff 5 zur Erzeugung einer Abdichtung des Verbindungsbereichs 3 auf. Bei dem Dichtstoff 5 kann es sich insbesondere um einen Dichtstoff 5 in einem flüssigen Zustand handeln.

Weiterhin weist die Anordnung eine Aufnahmekammer 6 für einen geschlossenen Behälter 7 auf, in dem sich der Dichtstoff 5 befindet.

Weiterhin weist die Anordnung ein Öffnungselement 9 für ein Öffnen des Behälters 7 auf, sowie einen, von der Aufnahmekammer 6 zu dem abzudichtenden Verbindungsbereich 3 führenden Kanal 8 für den Dichtstoff 5.

Wie skizziert, kann das Öffnungselement 9 in der Aufnahmekammer 6 ausgebildet sein.

Vorzugsweise ist das Öffnungselement 9 dazu ausgestaltet, das Öffnen des Behälters 7 durch ein Aufstechen des Behälters 7 zu erzielen. Dabei kann das Öffnungselement 9 hierfür insbesondere eine Spitze 10 aufweisen, wobei besonders bevorzugt die Spitze 10 relativ zu dem Behälter 7 derart angeordnet und ausgerichtet ist, dass sie zu dem Behälter 7 weist.

Weiterhin vorzugsweise ist der Kanal 8 sich durch das Öffnungselement 9 hindurch erstreckend gestaltet.

Weiterhin vorzugsweise weist die Anordnung ein Betätigungselement 12 auf, wobei die Gestaltung derart ist, dass das Betätigungselement 12 durch eine Manipulation von außerhalb des Innenraumbereichs 4 derart betätigt werden kann, dass hierdurch das Öffnen des Behälters 7 bewirkt wird sowie ein anschließendes Strömen des Dichtstoffs 5 durch den Kanal 8 zu dem Verbindungsbereich 3. Bei dem in Fig. 1 skizzierten ersten Ausführungsbeispiel ist die Gestaltung dabei derart, dass die Manipulation des Betätigungselements 12 eine Translationsbewegung umfasst, vorzugsweise aus der Translationsbewegung besteht. So lässt sich eine besonders einfache Handhabung erzielen. Insbesondere kann das Betätigungselement 12 als ein Schieber gestaltet sein.

Dabei ist die Gestaltung weiterhin vorzugsweise derart, dass durch die Manipulation des Betätigungselements 12 eine zum Öffnen des Behälters 7 führende Relativbewegung zwischen dem Behälter 7 und dem Öffnungselement 9 bewirkt werden kann. Im gezeigten Beispiel wird durch die Manipulation bewirkt, dass der Behälter 7 in der Aufnahmekammer 6 auf das Öffnungselement 9 zu bewegt wird, bis durch die Spitze 10 des Öffnungselements 9 der Behälter 7 aufgestochen wird.

Vorzugsweise ist das Betätigungselement 12 für die Betätigung bzw. die Manipulation beweglich an dem ersten Begrenzungselement 1 gelagert. Im gezeigten Beispiel ist die Gestaltung derart, dass das Betätigungselement 12 in bzw. an einem Wandbereich 15 des ersten Begrenzungselements 1 gelagert ist, wobei der Wandbereich 15 auch einen Wandbereich der Aufnahmekammer 6 darstellt. Insbesondere kann vorgesehen sein, dass die Aufnahmekammer 6 als ein Bestandteil des ersten Begrenzungselements 1 ausgestaltet ist, wobei das erste Begrenzungselement 1 vorzugsweise als aus einem Stück bestehend gestaltet ist. Auch der Kanal 8 ist vorzugsweise als ein Bestandteil bzw. weiterer Bestandteil des ersten Begrenzungselements 1 ausgestaltet.

Im gezeigten Beispiel ist ein Lager, vorzugsweise in Form eines Gleitlagers für das Betätigungselement 12 durch eine Durchgangsöffnung in dem Wandbereich 15 gebildet. Das Betätigungselement 12 weist dabei einen Schaftbereich 123 auf, der mit dem Lager wechselwirkt, hier also die Durchgangsöffnung durchsetzt.

An einem mit Bezug auf den Wandbereich 15 äußeren Endbereich weist das Betätigungselement 12 vorzugsweise einen Angriffsbereich 121 auf, der dazu vorgesehen ist, zur Durchführung der Manipulation gedrückt zu werden, wie in Fig. 1 durch einen Pfeil D angedeutet.

An einem mit Bezug auf den Wandbereich 15 inneren Endbereich weist das Betätigungselement 12 vorzugsweise einen Kolbenbereich 124 auf, der dafür vorgesehen ist, durch die Manipulation auf den Behälter 7 zu wirken. Da die Durchgangsöffnung in dem Wandbereich 15 gebildet ist, befindet sich der Kolbenbereich 124 innerhalb der Aufnahmekammer 6.

Der Kolbenbereich 124 kann vorteilhaft eine größere Querschnittfläche aufweisen als der Schaftbereich 123, so dass durch den Kolbenbereich 124 eine nach außen gerichtete Bewegung des Betätigungselements 12 begrenzt ist. Analog kann der Angriffsbereich 121 eine größere Querschnittfläche aufweisen als der Schaftbereich 123, so dass in umgekehrter Richtung durch den Angriffsbereich 121 eine einwärts gerichtete Bewegung des Betätigungselements 12 begrenzt ist.

Die Dimensionierung und Formgebung mit Bezug auf die Aufnahmekammer 6 und den Behälter 7 ist dabei vorzugsweise so gestaltet, dass ein Innenwandbereich 61 der Aufnahmekammer 6 eine Führung für eine, auf das Öffnungselement 9 gerichtete Bewegung des Behälters 7 bildet, die durch die Manipulation des Betätigungselements 12 bewirkt wird.

Der Ablauf bei der Betätigung bzw. der Manipulation des Betätigungselements 12 ist vorzugsweise wie folgt: Wenn das Betätigungselement 12 durch Druck auf den Angriffsbereich 121 wie vorgesehen manipuliert wird, gelangt aufgrund der Translationsbewegung des Betätigungselements 12 der Kolbenbereich 124 in Kontakt mit dem Behälter 7 und schiebt Letzteren, geführt durch den Innenwandbereich 61 auf das Öffnungselement 9 zu. Durch die weitere translatorische Bewegung des Betätigungselements 12 wird der Behälter 7 durch Wechselwirkung mit dem Öffnungselement 9, hier also durch das erwähnte Aufstechen des Behälters 7 geöffnet. Dann tritt durch den aufgestochenen Bereich im Behälter 7 der Dichtstoff 5 aus. Im Weiteren wird der Dichtstoff 5 durch den Kolbenbereich 121 in einen Abschnitt der Aufnahmekammer 6 gedrückt, in der sich das Öffnungselement 9 befindet und von dort in den Kanal 8 gedrückt, da sich Letzterer durch das Öffnungselement 9 hindurch erstreckt, also am Öffnungselement 9 in die Aufnahmekammer 6 mündet. Schließlich wird der Dichtstoff 5 durch den Kanal 8 hindurch gedrückt, bis er sich im Verbindungsbereich 3 verteilt.

Wenn der Verbindungsbereich 3 wie oben beispielhaft angegeben gestaltet ist, kann der Dichtstoff 5 dann in den Kanal 31 fließen und diesen füllen, bis er den Raumbereich zwischen dem Kanal 31 und dem Steg 32 abdichtend gefüllt hat. Anschießend kann der Dichtstoff 5 trocknen.

In Fig. 1 ist lediglich ein Kanal 8 skizziert. Allerdings kann die Anordnung vorzugsweise außerdem wenigstens einen weiteren Kanal für den Dichtstoff 5 aufweisen, der von der Aufnahmekammer 6 zu dem abzudichtenden Verbindungsbereich 3 führend gestaltet ist, insbesondere analog zu dem zuerst genannten Kanal 8. So kann vorteilhaft bewirkt werden, dass der Dichtstoff 5 über entsprechende mehrere Kanäle an unterschiedliche Stellen des Verbindungsbereichs 3 geleitet wird.

Die Gestaltung kann vorteilhaft derart sein, dass durch den getrockneten Dichtstoff 5 nicht nur eine Abdichtung des Innenraumbereichs 4 gebildet ist, sondern auch eine mechanische Verbindung zwischen den beiden Begrenzungselementen 1, 2 bzw. zwischen dem Gehäuse und der Abdeckung erzielt ist.

Es kann vorgesehen sein, dass während der Durchführung des oben beschriebenen Vorgangs das zweite Begrenzungselement 2 bzw. die Abdeckung durch weitere - nicht dargestellte - Maßnahmen vorab bereits leicht mechanisch an dem damit zu verbindenden ersten Begrenzungselement 1 bzw. dem Gehäuse befestigt wird. Während des Verklebens muss also das zweite Begrenzungselement 2 bzw. die Abdeckung nicht zwingend manuell in der gewünschten Position gehalten werden, sondern befindet sich bereits von Anfang an in dieser Position. Hierdurch wird die Durchführung des Abdichtens bzw. Verklebens nochmals vereinfacht.

Die Anordnung kann außerdem Verschlusselemente, beispielsweise Verschlussclips oder dergleichen aufweisen, die im verbundenen Zustand der beiden Begrenzungselemente 1, 2 die beiden Begrenzungselemente 1, 2 zusammenhaltend angeordnet werden können. Hierdurch lässt sich eine Sicherung der Verbindung erzielen.

Es kann auch ein Zweikomponenten-Dichtstoff verwendet werden. In diesem Fall sind die beiden Komponenten vorzugsweise in zwei entsprechenden Behältern angeordnet, die in der Aufnahmekammer 6 positioniert; natürlich können auch zwei entsprechende Aufnahmekammern vorgesehen sein, so dass jede Komponente in jeweils einem der beiden Aufnahmeräume gelagert ist.

Vorzugsweise weist die Anordnung außerdem eine Sicherungseinrichtung zur Verhinderung einer ungewollten Durchführung der Manipulation des Betätigungselements 12 auf. Hierdurch lässt sich insbesondere praktisch vermeiden, dass bereits während eines Transportvorgangs der Leuchte zu einem Betriebsort das Betätigungselement 12 ungewollt manipuliert wird.

Alternativ könnte die Gestaltung beispielsweise auch derart sein, dass das Betätigungselement 12 ein Hebelelement bildet und dementsprechend an dem ersten Begrenzungselement 1 drehbar gelagert angeordnet ist. Bei der vorgesehenen Manipulation durch eine Drehbewegung wird das Betätigungselement sozusagen umgelegt und es wirkt dann im Sinn eines Hebels auf den Behälter 7, so dass hierdurch das Öffnen des Behälters 7 und die anschließende Verteilung des Dichtstoffs 5 bewirkt werden kann.

Eine zweite mögliche Ausgestaltung des erfindungsgemäßen Konzepts ist in Fig. 2 dargestellt. Soweit nicht anders angegeben, gelten die obigen Ausführungen auch für das zweite Ausführungsbeispiel. Die Bezugszeichen sind in analoger Weise gebraucht.

Der Unterschied zum ersten Ausführungsbeispiel besteht in erster Linie in der Art und Weise der Betätigung, mit der der Vorgang zur Abdichtung initiiert wird. Wiederum ist ein entsprechender Behälter 7 vorgesehen, der den Dichtstoff 5 beinhaltet und der in einer Aufnahmekammer 6 positioniert ist.

Die Anordnung kann dabei - wie bereits oben anhand der Beschreibung des ersten Ausführungsbeispiels erwähnt - wenigstens einen weiteren Kanal 11 für den Dichtstoff 5 aufweisen, der von der Aufnahmekammer 6 zu dem abzudichtenden Verbindungsbereich 3 führend gestaltet ist. Dies ist vorteilhaft mit Bezug auf eine besonders gleichmäßige Verteilung des Dichtstoffs 5 in dem Verbindungsbereich 3. Insbesondere kann hierbei für den wenigstens einen weiteren Kanal 11 wenigstens ein entsprechendes weiteres Öffnungselement 9' gebildet sein, das dem zuerst genannten Öffnungselement 9 entsprechend gebildet ist.

Im Unterschied zum ersten Ausführungsbeispiel ist beim zweiten Ausführungsbeispiel das Betätigungselement - hier mit 12' bezeichnet - als ein Deckelement der Aufnahmekammer 6 gestaltet. Die Aufnahmekammer 6 als solche ist hierbei auf einer Seite offen gestaltet, wobei diese Seite durch das Deckelement bzw. das Betätigungselement 12' abgedeckt ist.

Beispielsweise kann die Gestaltung dabei derart sein, das Betätigungselement 12' über ein Gewinde drehbar an dem ersten Begrenzungselement 1 angeordnet ist, wobei durch ein Drehen des Betätigungselements 12' gegenüber dem Begrenzungselement 1 das Betätigungselement 12' auf den Behälter 7 zu bewegt wird und in der Folge der Behälter 7 durch das Öffnungselement 9 bzw. die Öffnungselemente 9, 9' geöffnet wird.

Es kann alternativ beispielsweise auch vorgesehen sein, dass - im Sinn der oben erwähnten Sicherungseinrichtung - durch ein Drehen des Betätigungselements 12' die Sicherungseinrichtung gelöst wird und anschließend durch einen Druck auf das Betätigungselement 12' Letzteres so verformt wird, dass hierdurch der Behälter 7 auf das Öffnungselement 9 bzw. die Öffnungselemente 9, 9' gedrückt und somit geöffnet wird.

Die anmeldungsgemäße Anordnung kann in vielfältiger Weise Verwendung finden. Beispielsweise kann - wie oben erwähnt - hierdurch eine Leuchte insgesamt feuchtigkeitsdicht oder auch wasserdicht verschlossen werden. Da jedoch im Rahmen der Montage einer Leuchte am Betriebsort oft noch ein Zugang zu den elektronischen Komponenten, also beispielsweise einem Konverter oder einer Anschlussklemme einer Leuchte gewünscht ist, könnten auch nur Teile einer Leuchte in entsprechender Weise abgedichtet werden, um die feuchtigkeitssensiblen Einheiten zu schützen. Die Anordnung kann also beispielsweise als Verteiler- oder Anschlussbox gestaltet sein. Auch eine Ausgestaltung der Anordnung ist in diesem Sinne vorteilhaft, bei der das erste Begrenzungselement 1 zur Halterung einer LED-Platine dient bzw. durch eine LED-Platine gebildet ist und das zweite Begrenzungselement 2 eine dazugehörige Abdeckung bildet. So kann die Anordnung vorteilhaft in Form einer so genannten "Light Engine" einer Leuchte ausgeführt sein.

## Patentansprüche

1. Anordnung zur Bildung eines abgedichteten, insbesondere feuchtigkeitsdicht abgedichteten Innenraumbereichs (4), aufweisend
- ein erstes Begrenzungselement (1) zur Bildung des Innenraumbereichs (4),
- ein zweites Begrenzungselement (2) zur Bildung des Innenraumbereichs (4), wobei es sich bei dem ersten Begrenzungselement (1) um ein Gehäuse einer Leuchte handelt und bei dem zweiten Begrenzungselement (2) um eine Abdeckung der Leuchte,
wobei das erste Begrenzungselement (1) mit dem zweiten Begrenzungselement (2) über einen, insbesondere ringartig geformten Verbindungsbereich (3) derart verbunden werden kann, dass hierdurch der Innenraumbereich (4) gebildet ist,
- ein Dichtstoff (5) zur Erzeugung einer Abdichtung des Verbindungsbereichs (3),
**dadurch gekennzeichnet,**
**dass** die Anordnung weiterhin eine Aufnahmekammer (6) für einen geschlossenen Behälter (7) aufweist, in dem sich der Dichtstoff (5) befindet, ein Öffnungselement (9) für ein Öffnen des Behälters (7), sowie einen, von der Aufnahmekammer (6) zu dem abzudichtenden Verbindungsbereich (3) führenden Kanal (8) für den Dichtstoff (5).

2. Anordnung nach Anspruch 1,
**dadurch gekennzeichnet,**
**dass** das Öffnungselement (9) dazu ausgestaltet ist, das Öffnen des Behälters (7) durch ein Aufstechen des Behälters (7) zu erzielen.

3. Anordnung nach Anspruch 1 oder 2,
**dadurch gekennzeichnet,**
**dass** der Kanal (8) sich durch das Öffnungselement (9) hindurch erstreckend gestaltet ist.

4. Anordnung nach einem der vorhergehenden Ansprüche,
**gekennzeichnet durch,**
ein Betätigungselement (12, 12'), wobei die Gestaltung derart ist, dass das Betätigungselement (12, 12') durch eine Manipulation von außerhalb des Innenraumbereichs (4) derart betätigt werden kann, dass hierdurch das Öffnen des Behälters (7) bewirkt wird sowie ein anschließendes Strömen des Dichtstoffs (5) durch den Kanal (8) zu dem Verbindungsbereich (3).

5. Anordnung nach Anspruch 4,
**dadurch gekennzeichnet,**
**dass** durch die Manipulation des Betätigungselements (12, 12') eine zum Öffnen des Behälters (7) führende Relativbewegung zwischen dem Behälter (7) und dem Öffnungselement (9) bewirkt werden kann.

6. Anordnung mit den im Anspruch 5 in seiner Rückbeziehung auf den Anspruch 2 genannten Merkmalen,
**dadurch gekennzeichnet,**
**dass** durch die Relativbewegung das Aufstechen des Behälters (7) erzielt wird.

7. Anordnung nach einem der Ansprüche 4 bis 6,
**dadurch gekennzeichnet,**
**dass** das Betätigungselement (12, 12') für die Manipulation beweglich an dem ersten Begrenzungselement (1) gelagert ist.

8. Anordnung nach einem der Ansprüche 4 bis 7,
**dadurch gekennzeichnet,**
**dass** die die Gestaltung derart ist, dass die Manipulation des Betätigungselements (12, 12') eine Translationsbewegung des Betätigungselements (12) oder eine Drehbewegung des Betätigungselements (12') umfasst, vorzugsweise aus einer Translationsbewegung des Betätigungselements (12) und/oder aus einer Drehbewegung des Betätigungselements (12') besteht.

9. Anordnung nach einem der Ansprüche 4 bis 8,
**gekennzeichnet durch**
eine Sicherungseinrichtung zur Verhinderung einer ungewollten Durchführung der Manipulation des Betätigungselements (12, 12').

10. Anordnung nach einem der vorhergehenden Ansprüche,
**dadurch gekennzeichnet,**
**dass** die Aufnahmekammer (6) als ein Bestandteil des ersten Begrenzungselements (1) ausgestaltet ist, wobei das erste Begrenzungselement (1) vorzugsweise als aus einem Stück bestehend gestaltet ist.

11. Anordnung nach Anspruch 10,
**dadurch gekennzeichnet,**
**dass** der Kanal (8) als ein weiterer Bestandteil des ersten Begrenzungselements (1) ausgestaltet ist.

12. Anordnung nach einem der vorhergehenden Ansprüche,
**gekennzeichnet durch**
wenigstens einen weiteren Kanal (11) für den Dichtstoff (5), der von der Aufnahmekammer (6) zu dem abzudichtenden Verbindungsbereich (3) führend gestaltet ist.

## Claims

1. Arrangement for forming a sealed, in particular moisture-tight sealed interior region (4), comprising:
- a first delimiting element (1) for forming the interior region (4),
- a second delimiting element (2) for forming the interior region (4),
wherein the first delimiting element (1) is a housing of a luminaire while the second delimiting element (2) is a cover of the luminaire,
wherein the first delimiting element (1) may be connected to the second delimiting element (2) via a connecting region (3) which is shaped, in particular, in such a manner as to form the interior region (4),
- a sealant (5) to seal of the connecting region (3),
**characterized in that**
the arrangement further comprises a receiving chamber (6) for a closed container (7) containing the sealant (5), an opening element (9) to open the container (7), as well as a duct (8) leading from the receiving chamber (6) to the sealed connecting region (3) for the sealant (5).

2. Arrangement according to claim 1,
**characterized in that**
the opening element (9) is designed to achieve the opening of the container (7) by piercing the container (7).

3. Arrangement according to claim 1 or 2,
**characterized in that**
the duct (8) is designed to extend through the opening element (9).

4. Arrangement according to one of the preceding claims,
**characterized in that**
an actuating element (12, 12') whose design is such that the actuating element (12, 12') may be actuated by manipulation from outside the interior region (4) in order to effect opening of the container (7) and subsequent flow of the sealant (5) through the duct (8) to the connecting region (3).

5. Arrangement according to claim 4,
**characterized in that**
by manipulating the actuating element (12, 12') for opening the container (7), a relative movement between the container (7) and the opening element (9) may be effected.

6. Arrangement according to claim 5 in its reference to claim 2,
**characterized in that**
the piercing of the container (7) is achieved by the relative movement.

7. Arrangement according to one of the claims 4 to 6,
**characterized in that**
the actuating element (12, 12') is movably mounted on the first delimiting element (1) for the manipulation.

8. Arrangement according to one of the claims 4 to 7,
**characterized in that**
the design is such that the manipulation of the actuating element (12, 12') comprises a translational movement of the actuating element (12) or a rotational movement of the actuating element (12'), preferably a translational movement of the actuating element (12) and/or a rotational movement of the actuating element (12').

9. Arrangement according to one of the claims 4 to 8,
**characterized In that**
a securing device prevents an unintended manipulation of the actuating element (12, 12').

10. Arrangement according to one of the preceding claims,
**characterized in that**
the receiving chamber (6) is designed as a part of the first delimiting element (1), wherein the first delimiting element (1) is preferably designed in one piece.

11. Arrangement according to claim 10,
**characterized in that**
the duct (8) is designed as a further part of the first delimiting element (1).

12. Arrangement according to one of the preceding claims,
**characterized in that**
at least one further duct (11) for the sealant (5) leads from the receiving chamber (6) to the connecting region (3) to be sealed.

## Revendications

1. Dispositif de formation d'une partie d'espace intérieur (4) étanche, plus particulièrement étanche à l'humidité, comprenant :
- un premier élément de limitation (1) pour la formation de la partie d'espace intérieur (4),
- un deuxième élément de limitation (2) pour la formation de la partie d'espace intérieur (4), le premier élément de limitation (1) étant un boîtier de luminaire et
le deuxième élément de limitation (2) étant un couvercle du luminaire,
le premier élément de limitation (1) pouvant être relié avec le deuxième élément de limitation (2) par l'intermédiaire d'une partie de liaison (3), plus particulièrement de forme annulaire, de façon à former la partie d'espace intérieur (4),
- un matériau d'étanchéité (5) pour la réalisation de l'étanchéité de la partie de liaison (3),
**caractérisé en ce que**
le dispositif comprend en outre une chambre de logement (6) pour un récipient fermé (7), dans lequel se trouve le matériau d'étanchéité (5), un élément d'ouverture (9) permettant d'ouvrir le récipient (7) ainsi qu'un canal (8) pour le matériau d'étanchéité (5), qui conduit de la chambre de logement (6) vers la partie de liaison (3) à étanchéifier.

2. Dispositif selon la revendication 1,
**caractérisé en ce que**
l'élément d'ouverture (9) est conçu pour permettre l'ouverture du récipient (7) par un percement du récipient (7).

3. Dispositif selon la revendication 1 ou 2,
**caractérisé en ce que**
le canal (8) est conçu de façon à s'étendre à travers l'élément d'ouverture (9).

4. Dispositif selon l'une des revendications précédentes,
**caractérisé par**
un élément d'actionnement (12, 12'), la conception étant telle que l'élément d'actionnement (12, 12') puisse être actionné par une manipulation de l'extérieur de la partie d'espace intérieur (4) de façon permettre l'ouverture du récipient (7) ainsi qu'un écoulement du matériau d'étanchéité (5) à travers le canal (8) vers la partie de liaison (3).

5. Dispositif selon la revendication 4,
**caractérisé en ce que**
la manipulation de l'élément d'actionnement (12, 12') permet d'obtenir un mouvement relatif entre le récipient (7) et l'élément d'ouverture (9) provoquant l'ouverture du récipient (7).

6. Dispositif présentant les caractéristiques mentionnées dans la revendication 5 en référence à la revendication 2,
**caractérisé en ce que**
le mouvement relatif permet d'obtenir le percement du récipient (7).

7. Dispositif selon l'une des revendications 4 à 6,
**caractérisé en ce que**
l'élément d'actionnement (12, 12') est logé, pour la manipulation, de manière mobile au niveau du premier élément de limitation (1).

8. Dispositif selon l'une des revendications 4 à 7,
**caractérisé en ce que**
la conception est telle que la manipulation de l'élément d'actionnement (12, 12') comprend un mouvement de translation de l'élément d'actionnement (12) ou un mouvement de rotation de l'élément d'actionnement (12'), de préférence est constituée d'un mouvement de translation de l'élément d'actionnement (12) et/ou d'un mouvement de rotation de l'élément d'actionnement (12').

9. Dispositif selon l'une des revendications 4 à 8,
**caractérisé par**
un dispositif de sécurisation permettant d'empêcher une manipulation indésirable de l'élément d'actionnement (12, 12').

10. Dispositif selon l'une des revendications précédentes,
**caractérisé en ce que**
la chambre de logement (6) est conçue comme un composant du premier élément de limitation (1), le premier élément de limitation (1) étant réalisé de préférence d'une seule pièce.

11. Dispositif selon la revendication 10,
**caractérisé en ce que**
le canal (8) est conçu comme un autre composant du premier élément de limitation (1).

12. Dispositif selon l'une des revendications précédentes,
**caractérisé par**
au moins un autre canal (11) pour le matériau d'étanchéité (5), qui est conçu de façon à conduire de la chambre de logement (6) vers la partie de liaison (3) à étanchéifier.
